# EUROPEAN PATENT SPECIFICATION

(11) **EP 0 452 634 B1**
(45) Date of publication and mention of the grant of the patent: **02.05.1997**
(21) Application number: 91102764.7
(22) Date of filing: 25.02.1991
(51) Int. Cl.: H01L 23/495

(54) **Lead frame for semiconductor device**
Leiterrahmen für Halbleiteranordnung
Cadre conducteur pour dispositif semi-conducteur

(30) Priority: 16.03.1990 JP 66179/90
(43) Date of publication of application: 23.10.1991
(73) Proprietor: SUMITOMO ELECTRIC INDUSTRIES, LTD., Osaka-shi, Osaka 541 (JP)
(72) Inventor: Go, Hisao, c/o Yokohama Works of, Sakae-ku, Yokohama-shi, Kanagawa (JP)
(74) Representative: Grünecker, Kinkeldey, Stockmair & Schwanhäusser Anwaltssozietät

(56) References cited:
- EP-A- 0 273 364
- PATENT ABSTRACTS OF JAPAN vol. 012, no. 009 (E-572) 12 January 1988, & JP-A- 62 169334
- PATENT ABSTRACTS OF JAPAN vol. 009, no. 133 (P-362) 08 June 1985, & JP-A- 60 017411
- PATENT ABSTRACTS OF JAPAN vol. 012, no. 221 (E-625) 23 June 1988,
- & JP-A- 63 015454

## Description

The present invention relates to a lead frame used, for example, as a component for producing a multi-core optical module.

A multi-core optical module, in which a plurality of optical operation elements (laser-diodes, photo diodes, etc.) are linked to a number of optical fibers, is used for building an optical communication system such as an optical local area network (LAN).

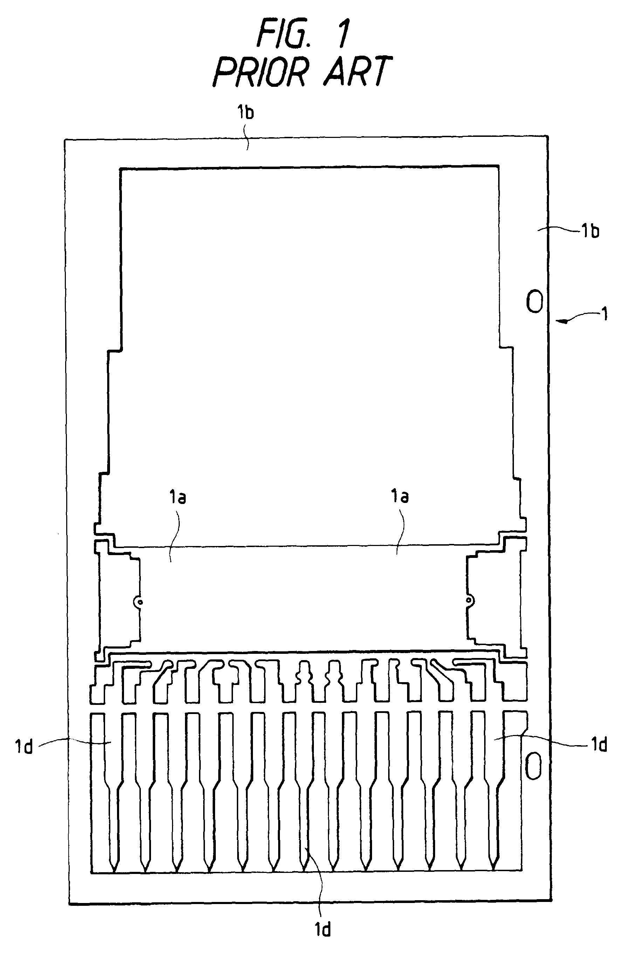

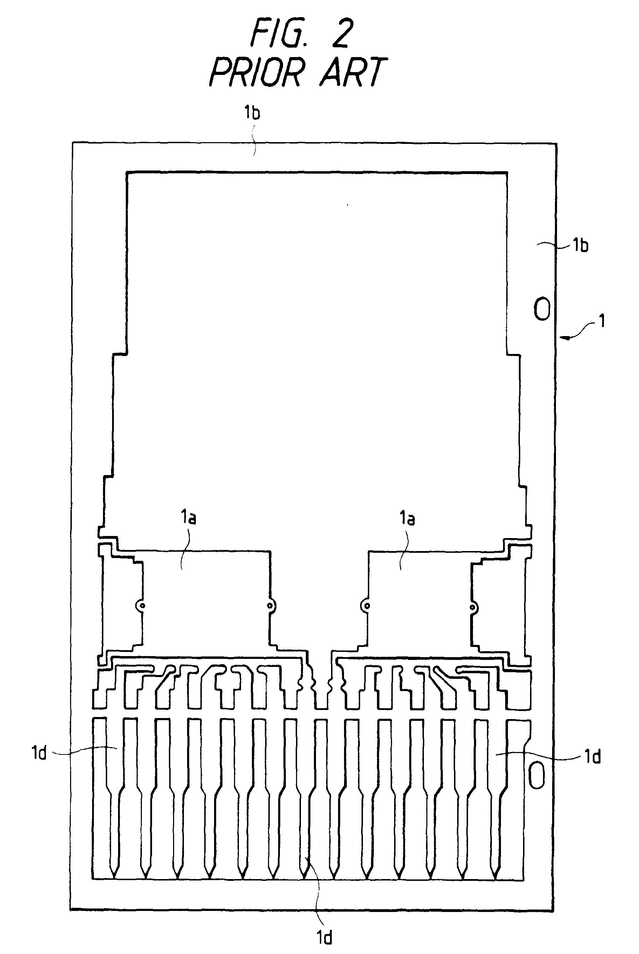

To produce such a multi-core optical module, electronic circuit elements are mounted on a substrate portion la of a lead frame (Fig. 1 or 2) and optical connectors fixing optical operation elements are connected to the substrate portion through wires. Subsequently, the lead frame is attached to a mold die, after which the multi-core optical module is produced by filling the mold die with resin.

However, when the optical operation elements including optical transmission circuits and optical receiving circuits are mounted on the single substrate portion la of the conventional lead fram 1 as shown in Fig. 1, signals of the optical transmission circuits may flow into the optical receiving circuits (cross talk) since they have a common ground, so that erroneous operations are apt to occur. Further, the substrate portion la has an unnecessarily large area, so that a thermal stress at and after the molding step may cause deterioration by cracks generated in a formed resin portion.

On the other hand, when the substrate portion la is divided into two parts as in the conventional lead frame 1 as shown in Fig. 2, each being supported by three portions to electrically insulate the circuits, the substrate portion la is apt to move before the molding step, so that wires connecting the optical operation element to the substrate portion la are apt to be damaged. Further, the substrate portion la is apt to vibrate due to an ultrasonic applied at the wire bonding, so that it is difficult to assure a sufficient strength of wire bonding.

EP-A-0 273 364 relates to a strip for carrying a plurality of small sized electronic parts such as LEDs which are embedded in a resin. The substrates of each electronic part are connected by lead wires which form a grid-like pattern.

An assembling method for a semiconductor device is known from JP-A-62 169 334 according to which a lead frame is prepared which supports a plurality of leads being connected to a substrate part. Thereby, each substrate is surrounded by one lead frame.

Document JP-A-60 017 411 describes an optical module supported by a lead frame wherein extending parts of the lead frame are adapted for positioning the optical module embedded in a mold body.

### SUMMARY OF THE INVENTION

The object of the present invention is to provide a lead frame in which a plurality of substrate portions are sufficiently fixed and are sufficiently insulated from each other in a final product.

This object is solved by a lead frame with the features of claim 1. Advantageous embodiments of the lead frame according to the present invention are defined in the dependent claims.

According to an embodiment of the invention a lead frame includes a frame portion, a plurality of substrate portions on which electronic circuit elements are to be mounted, and a support portion for supporting the plurality of substrate portions to the frame portion, the support portion having a plurality of separated end portions connected to the respective substrate portions at the position where a molded resin member is covered, and at least two of the plurality of end portions being combined into one body to be connected to the frame portion at the position where the molded resin member is not covered.

According to the lead frame of the present invention, since the respective substrate portions are connected to the support portion, the substrate portions are sufficiently fixed to the frame portion. Further, since the support portion has the separated end portions at the position where the molded resin member is covered, the plurality of substrate portions are insulated from each other by cutting the end portions after resin molding.

### BRIEF DESCRIPTION OF THE DRAWINGS

FIGs. 1 and 2 illustrate lead frames of prior art;
FIG. 3 shows the first embodiment of a lead frame according to the present invention; and
FIGs. 4 to 6 show lead frams according to the second, third, and fourth embodiments of the present invention, respectively.

### DETAILED DESCRIPTION OF THE INVENTION

Preferred embodiments of the present invention will be described with reference to the accompanying drawings.

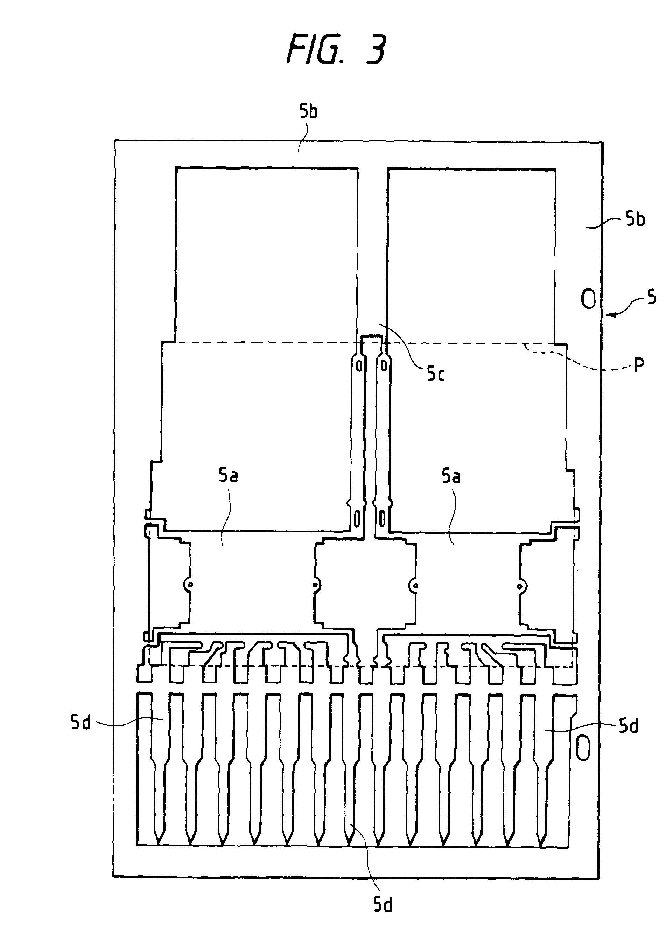

Fig. 3 shows a lead frame according to a first embodiment of the present invention. In Fig. 3, a lead frame 5 includes a support portion 5c disposed between a frame portion 5b and substrate portions 5a, and lead pins 5d. The lead frame is attached to a mold die at resin molding, and a resin is filled into a cavity of the mold die so that a package portion is formed. A dotted line in the figure schematically shows the package portion P formed integrally by the resin molding. The support portion 5c has two separated end portions inside the resin package portion P so as to support the respective substrate portions 5a and the lead pins 5d to the frame portion 5b. The separated end portions are combined into one body outside the package portion P to be connected to the frame portion 5b. Accordingly, the substrate portions 5a are sufficiently fixed to the frame portion 5b and the substrate portions are sufficiently insulated from each other by cutting the separated end portions after the resin molding.

When the above lead frame is used to form a multi-core optical module, electronic circuit elements are mounted on the substrate portions 5a and are connected to the lead pins 5d and to optical operation elements fixed to optical connectors. Then the lead frame is subjected to the resin molding to form the multi-core optical module.

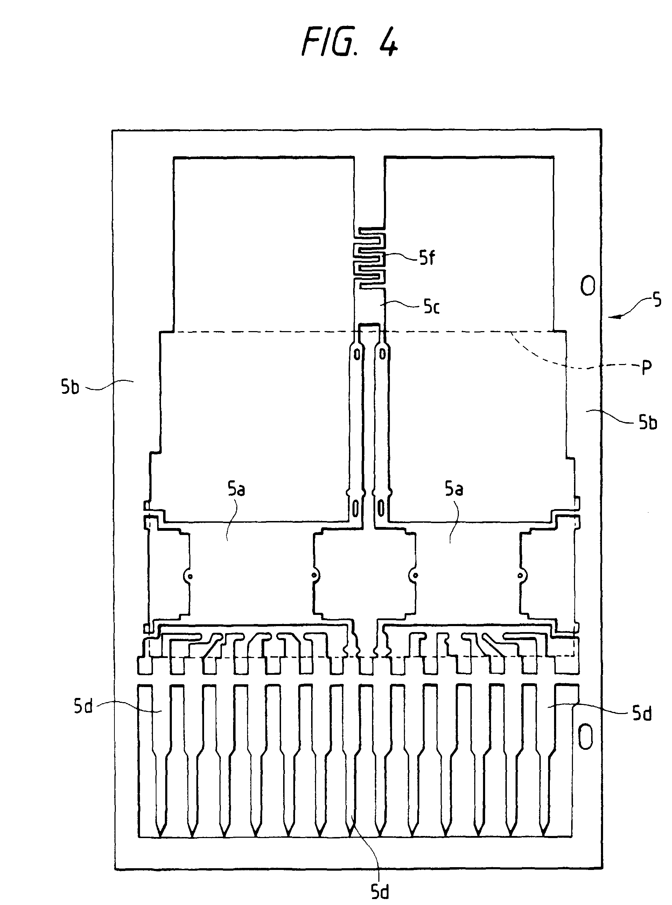

FIG. 4 shows a second embodiment of the present invention. The second embodiment is equivalent to the first embodiment except that the support portion 5c has a stress absorbing portion 5f which is a thin zigzag portion provided in the support portion 5c.

The stress absorbing portion 5f will readily deform under applied stress. Thus, even if the support portion 5c becomes shorter due to the contraction of resin after resin molding, the stress absorbing portion 5f will stretch to compensate, relieving the frame portion 5b from undesired stress. Since the frame portion 5b is no longer pushed, the lead pins 5d are no longer forced out of the inside of the formed resin. There is no clearance at the interface between the lead pins 5d and the formed resin portion, and consequently, humidity resistance and pull-out strength of the lead pins 5d are not diminished. Because no substantial stress is applied to the inner portion of the lead pins, wires bonded to the lead pin 5d are safe from breaking. Further, when unnecessary portions of the lead frame in a final product are cut off by a stamping die, it is possible to cut the portions at an accurate position, because there is no deformation of the frame portion caused by the undesired stress.

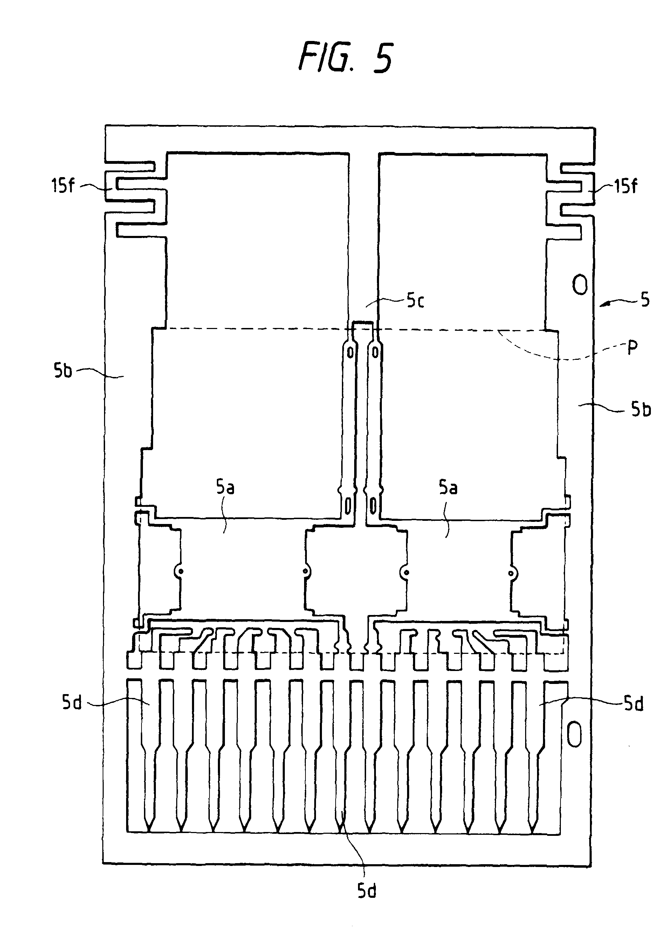

FIG. 5 shows a third embodiment of the present invention. This embodiment is equivalent to the second embodimet except that stress absorbing portions 15f are disposed on a frame portion 5b. In this embodiment, when the support portion 5c becomes shorter due to the contraction of resin after resin molding, the stress absorbing portions 15f will contract to compensate, releiving the frame portion 5b from undesired stress.

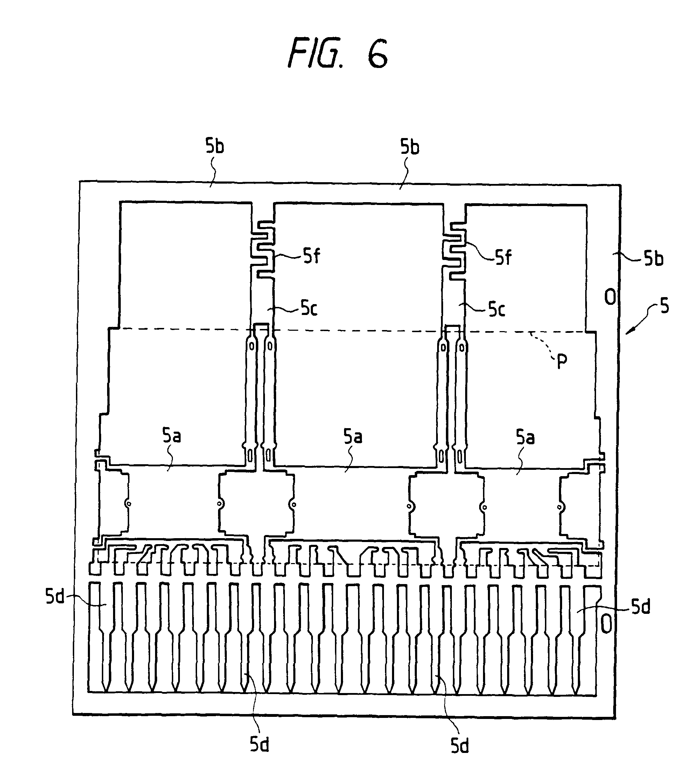

FIG. 6 shows a lead frame according to the fourth embodiment of the present invention. This embodiment is equivalent to the second embodiment shown in FIG. 4 except that three substrate portions 5a and two support portions 5c are provided. This embodiment has also the same effects as those in the former embodiments. That is, the present invention is also applicable to a multi-core optical module having more than three cores.

It will be readily apparent to those skilled in the art that other embodiments of the present invention may be implemented without departing from the scope of the invention, which is defined by the following claims.

## Claims

1. A lead frame, comprising:
a frame portion (5b) ;
a plurality of leads (5d) arranged along at least one side of said frame portion (5b) and connected thereto;
a plurality of chip support substrates (5a) each having a plurality of corners and being adapted for mounting electronic circuit elements thereon, and being arranged adjacent to said plurality of leads; and
each of said chip support substrates being attached to said frame portion by support portions attached to each of said corners thereof, whereby each support portion on a corner opposite said leads and adjacent an adjacent support substrate combines with an adjacent support portion of said adjacent substrate to form a single support portion region (5c) between said substrates (5a) and said frame portion (5b).

2. A lead frame (5) as claimed in claim 1, wherein a stress absorbing portion (5f) is disposed in said support portion region (5c).

3. A lead frame (5) as claimed in claim 1, wherein at least one stress absorbing portion (15f) is disposed in said frame portion (5b) for compensating a contraction of the support portion region.

4. A lead frame (5) as claimed in claim 2 or 3, wherein the stress absorbing portion (5f, 15f) has a zigzag-structure.

5. A lead frame (5) as claimed in claim 1, wherein the lead frame is used as a component for producing a multi-core optical module including a plurality of optical connectors fixing optical operation elements and electronic circuit elements connected to said optical operation elements, respective electronic circuit elements being mounted on respective ones of said plurality of chip support substrates (5a).

## Patentansprüche

1. Leiterrahmen, der umfaßt:
einen Rahmenabschnitt (5b);
eine Vielzahl von Leitern (5d), die an wenigstens einer Seite des Rahmenabschnitts (5b) angeordnet und damit verbunden sind;
eine Vielzahl von Chipträgersubstraten (5a), die jeweils eine Vielzahl von Ecken aufweisen und der Anbringung elektronischer Schaltungsbausteine daran dienen und an die Vielzahl von Leitern angrenzend angeordnet sind; und
wobei jedes der Chipträgersubstrate an den Rahmenabschnitt mit Halteabschnitten angebracht ist, die an jeder der Ecken derselben angebracht sind, wobei sich jeder Halteabschnitt an einer Ecke gegenüber den Leitern und an ein benachbartes Trägersubstrat angrenzend mit einem benachbarten Halteabschnitt des benachbarten Substrats vereinigt, so daß ein einzelner Halteabschnittsbereich (5c) zwischen den Substraten (5a) und dem Rahmenabschnitt (5b) entsteht.

2. Leiterrahmen (5) nach Anspruch 1, wobei ein Spannungsdämpfungsabschnitt (5f) in dem Halteabschnittsbereich (5c) angeordnet ist.

3. Leiterrahmen (5) nach Anspruch 1, wobei wenigstens ein Spannungsdämpfungsabschnitt (15f) in dem Rahmenabschnitt (5b) angeordnet ist, der ein Zusammenziehen des Halteabschnittsbereichs ausgleicht.

4. Leiterrahmen (5) nach Anspruch 2 oder 3, wobei der Spannungsdämpfungsabschnitt (5f, 15f) einen Zickzack-Aufbau hat.

5. Leiterrahmen (5) nach Anspruch 1, wobei der Leiterrahmen als ein Bauteil zur Herstellung eines mehraderigen optischen Moduls eingesetzt wird, das eine Vielzahl optischer Verbinder enthält, die optische Betriebselemente fixieren, sowie elektronische Schaltungsbausteine, die mit den optischen Betriebselementen verbunden sind, wobei die entsprechenden elektronischen Schaltungsbausteine auf entsprechenden der Vielzahl von Chipträgersubstraten (5a) angebracht sind.

## Revendications

1. Cadre conducteur comprenant :
- une partie de cadre (5b);
- une pluralité de conducteurs (5d) agencés le long d'au moins un côté de la partie de cadre (5b) et raccordés;
- une pluralité de bases de support de composant (5a) possédant chacune une pluralité de coins et prévues pour le montage d'éléments de circuit électronique et agencés de façon adjacente à ladite pluralité de conducteurs; et
- chacune desdites bases de support de composant étant fixée à ladite partie de cadre (5b) par des parties de support fixées à chacun de leurs dits coins, chaque partie de support sur un coin opposé auxdits conducteurs et adjacente à une base de support adjacente se combinant à une partie de support adjacente à ladite base de support adjacente pour former une seule zone de partie de support (5c) entre lesdites bases (5a) et ladite partie de cadre (5b).

2. Cadre conducteur (5) selon la revendication 1, dans lequel une partie d'absorption des contraintes (5f) est disposée dans ladite zone de partie de support (5c).

3. Cadre conducteur (5) selon la revendication 1, dans lequel au moins une partie d'absorption des contraintes (15f) est disposée dans ladite partie de cadre (5b) pour compenser une contraction de la zone de partie de support.

4. Cadre conducteur (5) selon la revendication 2 ou 3, dans lequel la partie d'absorption des contraintes (5f, 15f) présente une structure en zigzag.

5. Cadre conducteur (5) selon la revendication 1, dans lequel le cadre conducteur est utilisé comme composant pour la production d'un module optique à plusieurs noyaux comprenant une pluralité de connecteurs optiques fixant des éléments optiques fonctionnels et des éléments de circuit électronique raccordés auxdits éléments optiques fonctionnels, des éléments respectifs de circuit électronique étant montés sur des bases respectives de ladite pluralité de bases de support de composant (5a).
